(19) Europäisches Patentamt
European Patent Office
Office européen des brevets

(11) **EP 2 966 461 B1**

(12) **FASCICULE DE BREVET EUROPEEN**

(45) Date de publication et mention
de la délivrance du brevet:
**14.06.2017 Bulletin 2017/24**

(51) Int Cl.:
*H02H 7/20* *(2006.01)*    *H02S 50/00* *(2014.01)*
*H02H 1/00* *(2006.01)*    *G01R 31/08* *(2006.01)*
*G01R 31/12* *(2006.01)*

(21) Numéro de dépôt: **15175200.3**

(22) Date de dépôt: **03.07.2015**

(54) **PROCÉDÉ ET DISPOSITIF DE DÉTECTION D'ARCS ÉLECTRIQUES POUR INSTALLATIONS ÉLECTRIQUES À SOURCE DE COURANT CONTINU**

VERFAHREN UND VORRICHTUNG ZUR DETEKTION VON ELEKTRISCHEN LICHTBÖGEN FÜR ELEKTRISCHE ANLAGEN MIT GLEICHSTROMQUELLE

METHOD AND DEVICE FOR DETECTING ELECTRICAL ARCS FOR ELECTRICAL SYSTEMS WITH A DC SOURCE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.07.2014 FR 1456477**

(43) Date de publication de la demande:
**13.01.2016 Bulletin 2016/02**

(73) Titulaire: **Schneider Electric Industries SAS
92500 Rueil-Malmaison (FR)**

(72) Inventeur: **DJEDDI, Mounir
38050 GRENOBLE Cedex 09 (FR)**

(74) Mandataire: **Lavoix
62, rue de Bonnel
69448 Lyon Cedex 03 (FR)**

(56) Documents cités:
**FR-A1- 2 983 968    US-A1- 2012 134 058**

• **XIU YAO ET AL: "The detection of DC arc fault: Experimental study and fault recognition", APPLIED POWER ELECTRONICS CONFERENCE AND EXPOSITION (APEC), 2012 TWENTY-SEVENTH ANNUAL IEEE, IEEE, 5 février 2012 (2012-02-05), pages 1720-1727, XP032127899, DOI: 10.1109/APEC.2012.6166054 ISBN: 978-1-4577-1215-9**

EP 2 966 461 B1

**Description**

La présente invention concerne un procédé et dispositif de détection d'arcs électriques pour installations électriques à source de courant continu.

Elle se situe dans le domaine de la protection des installations électriques.

L'invention trouve une application particulière dans le domaine des installations photovoltaïques, comportant des panneaux photovoltaïques comme sources d'énergie électrique en courant continu. Dans les installations photovoltaïques, un dispositif onduleur apte à transformer le courant électrique continu en courant alternatif à injecter dans le réseau de distribution électrique est connecté aux panneaux photovoltaïques.

D'une manière générale, l'invention s'applique pour tout autre type d'installation électrique comportant une ou plusieurs sources de courant électrique continu, branchées à une charge, notamment lorsque le câble de connexion entre sources de courant et charges est long.

Dans de telles installations, il est possible de constater, sur la longueur du câble connexion, des défauts d'isolement. Des arcs électriques peuvent alors se produire, induisant un risque d'incendie et un risque de sécurité pour des agents de maintenance. De plus, les charges branchées en aval risquent également d'être endommagées, ce qui induit des coûts de réparation et de remplacement.

Les problèmes liés à l'apparition des arcs électriques sont bien connus, et il existe diverses méthodes de détection de présence d'arc électrique le plus tôt possible, afin de réaliser une coupure du circuit électrique et d'éviter l'apparition d'incendie, l'accident d'agent de maintenance et l'endommagement des charges.

Xiu Yao et al : « The detection of DC arc fault : Experimental study and fault recognition", Applied Power Electronics Conference and Exposition (APEC), 5 février 2012, pages 1720-1727, divulgue un procédé de detection d'arcs pour installations électriques à source de courant continu.

Dans le domaine des sources de courant continu des installations photovoltaïques, il est particulièrement difficile d'appliquer certaines méthodes connues, du fait de la présence de charges résistives et de la résistance du câble de connexion de grande longueur. Dans certains cas de figure le courant d'arc est faible et il a été observé par simulation que le spectre du courant en cas de présence d'arc est très proche du spectre du courant en l'absence d'arc, ce qui rend la détection d'arc électrique très difficile.

L'invention a pour objectif de proposer une méthode de détection d'arc électrique pour installations électriques à source de courant continu, qui est efficace même dans les cas où le courant d'arc électrique est faible.

A cet effet, l'invention propose, selon un premier aspect, un procédé de détection d'arcs électriques pour installations électriques à source de courant continu, mis en oeuvre par un dispositif de détection comportant un processeur de calcul, disposé entre la source de courant continu et une charge.

Le procédé de l'invention comporte des étapes de :

- obtention d'un signal temporel numérisé à partir du courant électrique fourni par la source de courant continu,
- pour une pluralité de fenêtres temporelles successives de durée temporelle prédéterminée :

  - extraction d'un sous-signal temporel numérisé dudit signal temporel numérisé correspondant à une fenêtre temporelle courante,
  - application d'un filtrage passe-bande audit sous-signal temporel numérisé,
  - calcul d'une valeur statistique d'ordre quatre du sous-signal temporel numérisé filtré,
  - comparaison de la valeur statistique d'ordre quatre calculée à un premier seuil statistique et/ou à un deuxième seuil statistique, et dans le cas où la valeur statistique d'ordre quatre est inférieure au premier seuil statistique, ou dans le cas où la valeur statistique d'ordre quatre est supérieure au deuxième seuil statistique, mémorisation d'une indication de détection positive pour la fenêtre temporelle courante,

- détection de présence d'arc électrique lorsque le nombre d'indications de détection positive mémorisées dépasse un seuil de détection prédéterminé.

Avantageusement, le procédé de détection d'arc électrique selon l'invention comporte l'extraction de sous-signaux temporels et l'analyse de statistiques de quatrième ordre dans plusieurs fenêtres temporelles pour détecter la présence d'arc électrique.

Le procédé selon l'invention est efficace même lorsque le courant d'arc est faible, et il rapide d'un point de vue calculatoire.

Le procédé de détection d'arcs électriques selon l'invention peut également présenter une ou plusieurs des caractéristiques ci-dessous.

Ce procédé comporte, pour un dit sous-signal temporel numérisé correspondant à une fenêtre temporelle courante, une détermination d'une valeur de maximum d'enveloppe du sous-signal temporel numérisé, et une mise à jour de ladite indication de détection positive en fonction de la valeur statistique d'ordre quatre calculée et de la valeur de maximum d'enveloppe calculée.

La détermination d'une valeur de maximum d'enveloppe du sous-signal temporel numérisé est effectuée lorsque ladite valeur statistique d'ordre quatre est supérieure au premier seuil statistique et inférieure au deuxième seuil statistique.

Le procédé comporte en outre, lorsque la valeur statistique d'ordre quatre est supérieure au premier seuil statistique et inférieure à un seuil statistique intermédiaire, une comparaison de la valeur de maximum d'enveloppe à un premier seuil d'enveloppe, et une détection de présence d'arc électrique si de la valeur de maximum d'enveloppe est supérieure audit premier seuil d'enveloppe.

Lorsque la valeur statistique d'ordre quatre est supérieure au seuil statistique intermédiaire et inférieure au deuxième seuil statistique, le procédé comporte une comparaison de la valeur de maximum d'enveloppe à un deuxième seuil d'enveloppe, et une détection de présence d'arc électrique si de la valeur de maximum d'enveloppe est supérieure audit deuxième seuil d'enveloppe.

Le procédé comporte un calcul d'un coefficient de variation fonction de la moyenne et de la valeur statistique d'ordre deux du sous-signal temporel numérisé correspondant à la fenêtre temporelle courante avant filtrage passebande, et une mise à jour de ladite indication de détection positive lorsque ledit coefficient de variation dépasse un seuil de variation prédéterminé.

Pour chaque fenêtre temporelle courante, la mémorisation d'une indication de détection d'arc électrique dans une mémoire tampon circulaire de taille prédéterminée est mise en oeuvre.

Selon une caractéristique, le seuil de détection est calculé en fonction de la taille de la mémoire tampon circulaire.

Selon une caractéristique, deux fenêtres temporelles successives présentent un recouvrement d'une durée de recouvrement prédéterminée.

Le filtrage passe-bande est défini par une première fréquence F1 et une deuxième fréquence F2, ladite première fréquence étant fonction d'une fréquence de coupure de ladite charge, ladite deuxième fréquence étant fonction d'une fréquence d'échantillonnage d'un convertisseur analogique-numérique permettant d'obtenir ledit signal temporel numérisé.

Selon un deuxième aspect, l'invention concerne un dispositif de détection d'arcs électriques pour installations électriques à source de courant continu, comportant un processeur de calcul, disposé entre la source de courant continu et une charge.

Le dispositif comporte :

- un module d'obtention d'un signal temporel numérisé à partir du courant électrique fourni par la source de courant continu,
  pour application à une pluralité de fenêtres temporelles successives de durée temporelle prédéterminée,

  - une unité d'extraction d'un sous-signal temporel numérisé dudit signal temporel numérisé correspondant à une fenêtre temporelle courante,
  - un module de filtrage passe-bande audit sous-signal temporel numérisé,
  - un module de calcul d'une valeur statistique d'ordre quatre du sous-signal temporel numérisé filtré,
  - un module de décision, apte à effectuer une comparaison de la valeur statistique d'ordre quatre calculée à un premier seuil statistique et/ou à un deuxième seuil statistique, et dans le cas où la valeur statistique d'ordre quatre est inférieure au premier seuil statistique, ou dans le cas où la valeur statistique d'ordre quatre est supérieure au deuxième seuil statistique, une mémorisation d'une indication de détection positive pour la fenêtre temporelle courante,

- le module de décision étant apte à détecter de présence d'arc électrique lorsque le nombre d'indications de détection positive mémorisées dépasse un seuil de détection prédéterminé.

Le dispositif de détection d'arcs électriques selon l'invention peut également présenter une ou plusieurs des caractéristiques ci-dessous.

Il comporte un module déclenchement d'une unité de sécurité en réponse à un signal de déclenchement envoyé par le module de décision.

L'unité d'extraction d'un sous-signal temporel numérisé dudit signal temporel numérisé correspondant à une fenêtre temporelle courante comporte un capteur de courant électrique et un convertisseur analogique-numérique ayant une fréquence d'échantillonnage donnée.

Le module de filtrage passe-bande est apte à effectuer un filtrage entre une première fréquence F1 et une deuxième fréquence F2, ladite première fréquence étant fonction d'une fréquence de coupure de ladite charge, ladite deuxième fréquence étant fonction de la fréquence d'échantillonnage.

Il comporte un module de calcul d'enveloppe dudit sous-signal temporel numérisé correspondant à une fenêtre temporelle courante, une valeur de maximum d'enveloppe du sous-signal temporel numérisé étant transmise audit module de décision.

Il comporte un module de calcul de variation apte à calculer un coefficient de variation fonction de la moyenne et de la valeur statistique d'ordre deux du sous-signal temporel numérisé correspondant à la fenêtre temporelle courante avant filtrage passe-bande, et à transmettre le coefficient de variation calculé audit module de décision.

D'autres caractéristiques et avantages de l'invention ressortiront de la description qui en est donnée ci-dessous, à titre indicatif et nullement limitatif, en référence aux figures annexées, parmi lesquelles :

- la figure 1 représente schématiquement une installation électrique comportant un dispositif de détection de présence d'arcs électriques selon un mode de réalisation de l'invention ;
- la figure 2 représente schématiquement un ensemble de blocs fonctionnels d'un dispositif de détection d'arcs électriques selon un mode de réalisation l'invention ;
- la figure 3 illustre des modules fonctionnels mis en oeuvre par un dispositif de calcul d'un dispositif de détection d'arcs électriques selon l'invention ;
- la figure 4 illustre schématiquement des échantillons de sous-signaux temporels numérisés ;
- la figure 5 est un synoptique des principales étapes d'un procédé de détection d'arcs électriques selon un mode de réalisation de l'invention.

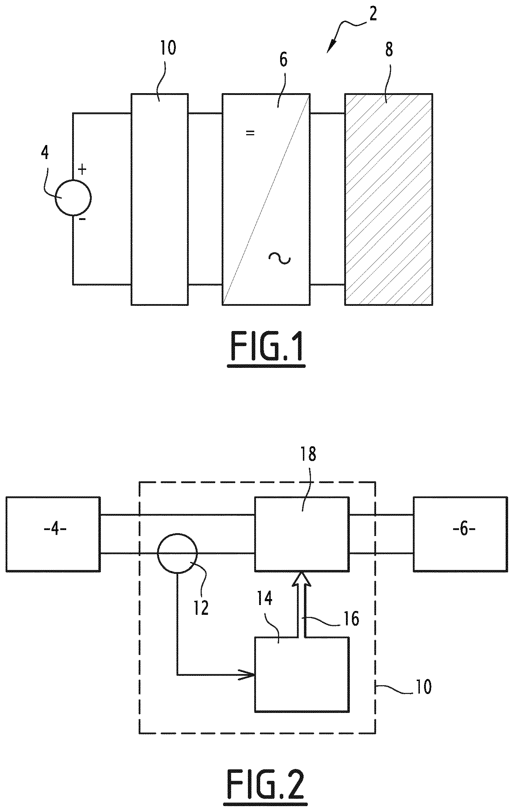

La figure 1 illustre schématiquement une installation électrique 2 dans laquelle l'invention trouve une application.

Dans le mode de réalisation illustré il s'agit d'une installation électrique 2 photovoltaïque, comportant une source de courant continu 4, formée par exemple d'un ensemble de panneaux solaires, connectée dans le circuit de l'installation électrique 2 à un onduleur 6.

L'onduleur 6 est apte à transformer le courant électrique continu fourni par la source 4 en courant électrique alternatif de fréquence 50Hz, permettant d'alimenter un réseau électrique 8.

Le circuit de l'installation 2 comporte également un dispositif de détection de présence d'arcs électriques 10, dont les blocs fonctionnels principaux sont décrits plus en détail en référence à la figure 2.

Le dispositif de détection de présence d'arcs électriques 10 comporte un capteur de courant électrique 12 qui est apte à récupérer le signal correspondant au courant électrique DC, et à le numériser pour fournir un signal temporel numérisé en entrée d'un dispositif de calcul 14 apte à effectuer des traitements de signal numérique.

Le dispositif de calcul 14 est par exemple un microcontrôleur ou un processeur de signal numérique, appelé également DSP pour « Digital Signal Processor ». Le dispositif 14 comporte notamment un microprocesseur, des mémoires et des interfaces d'entrée-sortie 16 permettant d'envoyer des ordres de commande à une unité 18 de sécurité, apte à effectuer une ouverture du circuit de manière à éliminer la propagation d'arc électrique détecté.

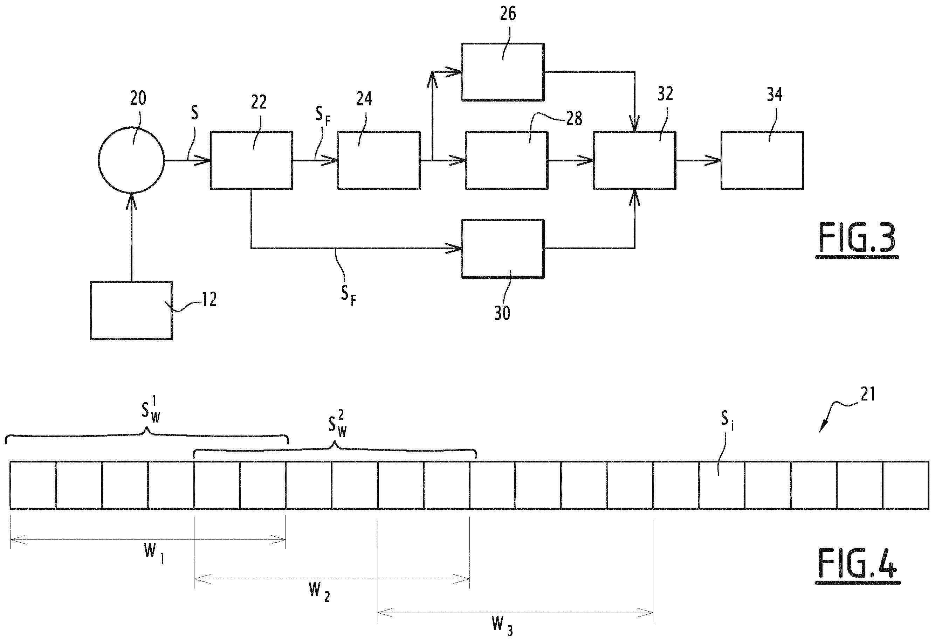

Le dispositif 14 est programmé pour mettre en oeuvre des modules fonctionnels de décision tels qu'illustrés schématiquement à la figure 3.

Comme illustré à la figure 3, le capteur de courant électrique DC 12 récupère le signal correspondant, et l'unité 20 de conversion analogique /numérique fournit un signal temporel numérisé S qui est mémorisé au fur et à mesure de son acquisition, de préférence dans une mémoire tampon (ou buffer en terminologie anglo-saxonne) des échantillons numériques.

Une unité 22 d'extraction de sous-signal temporel numérisé correspondant à une fenêtre temporelle glissante, définie entre un instant temporel $T_0$ et un instant temporel $T_0+\Delta t$, est appliquée pour extraire un sous-signal temporel numérisé $S_F$. Par exemple, $\Delta t=0,2$ secondes, ce qui correspond à K échantillons du signal numérique.

L'unité d'extraction 22 est appliquée successivement en appliquant la fenêtre glissante, deux extractions successives ayant de préférence une zone de recouvrement de dt secondes correspondant à r échantillons.

Par exemple, la zone de recouvrement est égale à $dt=0,5 \times \Delta t$. De manière plus générale, dt est compris entre $0,1 \times \Delta t$ et $0,9 \times \Delta t$.

A la figure 4, les échantillons $S_i$ du signal temporel numérisé sont mémorisés dans la mémoire 21, et des sous-signaux temporels numérisés $Sw_1$, $Sw_2$ et ainsi de suite sont extraits de la mémoire tampon 21, pour des fenêtres temporelles $W_1$, $W_2$ avec un recouvrement de $r=2$ échantillons dans cet exemple.

Les sous-signaux temporels numérisés sont traités ensuite par les modules de traitement respectifs 24 et 26 à 28.

Le module de filtrage 24 applique un filtrage passe-bande, entre une première fréquence F1 et une deuxième fréquence F2, par exemple F1=50kHz (kilo-Hertz) et F2=90kHz.

D'autres valeurs de première fréquence et deuxième fréquence peuvent être sélectionnées pour la définition du filtrage passe bande.

D'une manière plus générale, la première fréquence est choisie en fonction de la fréquence de coupure de la charge 6, et la deuxième fréquence est choisie en fonction de la fréquence d'échantillonnage de la conversion analogique numérique appliquée au signal temporel représentatif du courant électrique. Par exemple, pour un échantillonnage à 200kHz, une deuxième fréquence de 90kHz est sélectionnée.

Dans un premier mode de réalisation, le module de filtrage 24 est implémenté par le dispositif de calcul 14 tel que décrit ci-dessus.

Dans un mode de réalisation alternatif, le module de filtrage 24 est implémenté par un circuit analogique de filtrage.

Un sous-signal temporel numérisé filtré est obtenu en sortie du module de filtrage 24.

Le module de calcul statistique 26 effectue un calcul d'une valeur statistique d'ordre 4 ou kurtosis, également appelé coefficient d'aplatissement, de chaque sous-signal temporel numérisé filtré, et le module de calcul d'enveloppe 28 effectue le calcul du maximum de l'enveloppe de chaque sous-signal temporel numérisé filtré, comme expliqué plus en détail ci-après.

Le module de calcul de variation 30 effectue un calcul de coefficient de variation du sous-signal temporel avant filtrage passe-bande, pour chaque sous-signal temporel numérisé extrait par l'unité d'extraction 22.

Dans un mode de réalisation, les modules de calcul statistique 26, de calcul d'enveloppe 28 et de calcul de variation 30 sont mis en oeuvre sensiblement en parallèle. Chacun des modules de calcul fournit un indicateur de détection de présence d'arc électrique, le cas échéant, pour chaque sous-signal temporel numérisé correspondant à une fenêtre temporelle, à un module de décision 32.

Dans un mode de réalisation alternatif, le module de calcul statistique 26 est appliqué dans un premier temps, et, les modules de calcul d'enveloppe 28 et de calcul de variation 30 sont appliqués ultérieurement, en fonction du résultat du module de calcul statistique 26.

Le module de décision 32 mémorise des indications de détection de présence d'arc pour une pluralité de sous-signaux temporels numérisés correspondant chacun à une fenêtre temporelle, et effectue une détermination de détection d'arc électrique en fonction de la pluralité des indications de détection d'arc.

Dans un mode de réalisation, les indications de détection d'arc sont représentées sous forme de drapeaux prenant une valeur binaire indiquant respectivement la détection de présence ou d'absence d'arc électrique pour un sous-signal temporel numérisé correspondant à une fenêtre temporelle donnée, et sont mémorisées dans une mémoire tampon de détection d'arc, de type circulaire et de capacité donnée N.

Le module de décision 32 décide de la présence d'un arc électrique lorsque la mémoire tampon de détection d'arc contient au moins n indications positives parmi les N indications mémorisées.

De préférence, n est compris entre 30% de N et 100% de N.

En cas de décision positive par le module de décision 32, ce module envoie un signal de déclenchement à un module 34 de déclenchement de l'unité de sécurité 18, afin de provoquer une ouverture du circuit électrique.

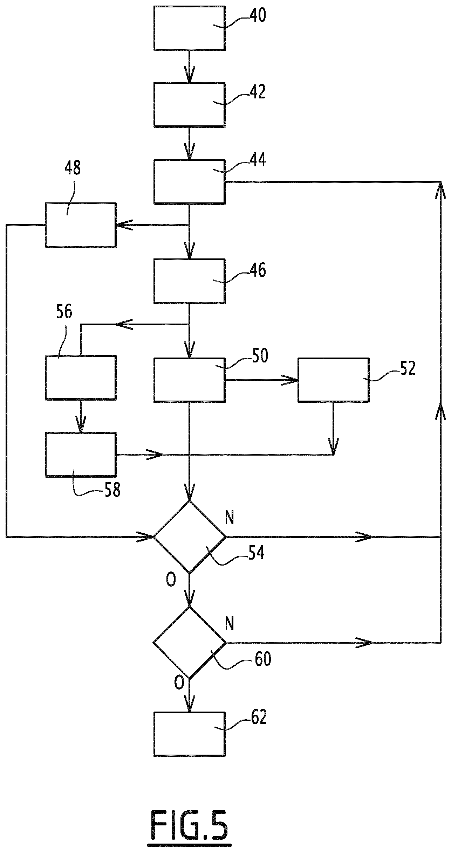

La figure 5 est un synoptique des principales étapes d'un procédé de détection d'arcs électriques pour installations électriques à source de courant continu selon un mode de réalisation de l'invention.

Dans une première étape 40 d'acquisition de signal électrique, le signal temporel représentatif du courant électrique continu issu de la source de courant continu est acquis.

Ce signal temporel est numérisé par un convertisseur analogique numérique lors de l'étape de numérisation 42, et les échantillons de signal temporel numérisé obtenus sont mémorisés dans une mémoire tampon des échantillons numériques. Dans un exemple de réalisation, une numérisation à 200kHz est effectuée.

Un sous-signal temporel numérisé est extrait lors de l'étape d'extraction de sous-signal 44, pour une fenêtre temporelle courant comprise entre un instant initial $T_0$ et un instant final $T_0+\Delta t$ donnés.

Le signal temporel numérisé est filtré lors d'une étape de filtrage passe-bande 46, par exemple par un filtre de Butterworth d'ordre 6 entre une première fréquence de 50kHz et une deuxième fréquence de 90kHz.

L'ensemble des échantillons numériques du sous-signal temporel numérisé extrait est également fourni en entrée d'une étape de calcul de coefficient de variation 48.

Pour un sous-signal temporel numérisé Sw composé d'échantillons $S_W(1)$ à $S_W(K)$, le coefficient de variation $C_v(S_W)$ est donné par :

$$C_v(S_W) = 100x\frac{\mu(S_W)}{\sigma(S_W)} \qquad \text{(Eq 1)}$$

Où $\mu(S_W)$ est la moyenne du sous-signal temporel numérisé $S_W$, ou statistique de premier ordre :

$$\mu(S_W) = E[S_W] = \frac{1}{K}\sum_{i=1}^{K} S_W(i) \quad \text{(Eq 2)}$$

E[X] désignant l'espérance mathématique d'une variable X.

Et $\sigma(S_W)$ est l'écart-type du sous-signal temporel numérisé $S_W$, ou statistique de deuxième ordre :

$$\sigma(S_W) = \sqrt{E\left[(S_W - \mu(S_W))^2\right]} = \sqrt{\frac{1}{K}\sum_{i=1}^{K}(S_W(i) - \mu(S_W))^2} \quad \text{(Eq 3)}$$

Après filtrage du sous-signal temporel numérisé lors de l'étape de filtrage passe-bande 46, la moyenne et la variance du sous-signal temporel numérisé filtré $S_{WF}$ sont calculées dans l'étape 50 de calcul des statistiques d'ordre 1 et 2 après filtrage :

$$\mu(S_{WF}) = E[S_{WF}] = \frac{1}{K}\sum_{i=1}^{K} S_{WF}(i) \quad \text{(Eq 4)}$$

$$\sigma^2(S_{WF}) = E\left[(S_{WF} - \mu(S_{WF}))^2\right] \quad \text{(Eq 5)}$$

La valeur statistique d'ordre 4 ou kurtosis du sous-signal temporel numérisé filtré $S_{WF}$ est calculée lors de l'étape de calcul de statistique d'ordre supérieur 52, effectuée après le calcul des statistiques d'ordre 1 et 2.

Le kurtosis est défini, pour un sous-signal temporel numérisé filtré $S_{WF}$, par :

$$K(S_{WF}) = \frac{E\left[(S_{WF} - \mu(S_{WF}))^4\right]}{\sigma^4(S_{WF})} \quad \text{(Eq 6)}$$

Pour un sous-signal temporel numérisé filtré $S_{WF}$ donné, on obtient ainsi une valeur de kurtosis. Lorsque la distribution des échantillons du sous-signal temporel numérisé filtré $S_{WF}$ est une Gaussienne normalisée, la valeur de kurtosis est K=3.

La valeur de kurtosis obtenue pour un sous-signal temporel numérisé filtré $S_{WF}$ est fournie à une étape de détection 54 pour une fenêtre temporelle donnée.

L'étape de détection 54 met en oeuvre des tests de détection d'arc fournissant chacun un indicateur de détection de présence ou d'absence d'arc électrique, pour le sous-signal temporel numérisé correspondant à la fenêtre temporelle courante.

Il a été constaté, suite à des tests expérimentaux effectués par les inventeurs, que lorsque la valeur du kurtosis $K(S_{WF})$ calculée pour un sous-signal temporel numérisé filtré $S_{WF}$ donné est inférieure à un premier seuil statistique $K_1$, ou est supérieure à un deuxième seuil statistique $K_2$, la détection de présence d'arc électrique est positive.

De préférence, le premier seuil statistique est $K_1$=2,1 et le deuxième seuil statistique est $K_2$=5.

De manière générale $K_1$ =2,1±$\Delta K_1$ et $K_2$=5±$\Delta K_2$ ici $\Delta K_1$ et $\Delta K_2$ sont définis de manière à ce que la détection de l'arc est toujours optimale, avec $\Delta K_1$ =0,1 et $\Delta K_2$ =0,1.

Un premier test effectué dans l'étape de détection 54 consiste à comparer la valeur du kurtosis $K(S_{WF})$ calculée au premier seuil $K_1$ et au deuxième seuil $K_2$.

Si le premier test indique que $K(S_{WF}) \leq K_1$ ou que $K(S_{WF}) \geq K_2$, un premier indicateur binaire $Ind_1$ est alors mis à 1.

De manière plus générale, un premier indicateur $Ind_1$ est mis à une valeur indiquant une détection d'arc électrique positive pour le sous-signal temporel numérisé $S_W$ considéré.

Le procédé comprend également une étape 56 de calcul d'un signal d'enveloppe du sous-signal temporel numérisé $S_W$ considéré et une étape 58 de calcul de maximum d'enveloppe de ce sous-signal.

L'étape 56 est effectuée sensiblement en parallèle avec l'étape de calcul de statistique d'ordre supérieur 52 ou après l'étape de calcul de statistique d'ordre supérieur 52.

Elle comporte le calcul d'un signal d'enveloppe à partir du sous-signal temporel numérisé filtré $S_{WF}$ :

$$Y(n) = S_{WF}(i) + j \cdot H(S_{WF}(i)) \quad \text{(Eq 7)}$$

Où j est l'unité du domaine imaginaire et H(X) est la transformée de Hilbert d'un signal X.

Ensuite, lors de l'étape 58, le maximum en valeur absolue du signal analytique Y(i) est calculé.

Le maximum d'enveloppe, noté MaxEnv($S_{WF}$), est calculé comme suite :

$$MaxEnv(S_{WF}) = MAX\left(\left|Y(i)\right|\right) \text{ (Eq 8)}$$

Où *MAX* ($\cdot$) est la fonction maximum et $|Y(i)|$ est la valeur absolue de l'amplitude du signal *Y(i)*.

La valeur de maximum d'enveloppe obtenue est également est fournie à l'étape de détection 54.

Dans l'étape de détection 54, la valeur de maximum d'enveloppe MaxEnv($S_{WF}$) est utilisée avec la valeur de kurtosis $K(S_{WF})$ calculée pour le sous-signal temporel numérisé filtré courant pour effectuer un deuxième test de détection de présence d'arc électrique.

Si la valeur de K(Swf) est comprise entre le premier seuil statistique $K_1$ est une valeur de seuil statistique intermédiaire $K_{int}$ et si la valeur du maximum d'enveloppe du sous signal MaxEnv(Swf) est supérieure à un premier seuil d'enveloppe $ME_1$, alors un deuxième indicateur Ind2 est mis à une valeur indiquant une détection d'arc électrique positive pour le sous signal temporel numérisé Sw considéré.

De préférence $K_{int}=3,3$ et $ME_1=0,3$

Si la valeur de K(Swf) est comprise entre la valeur de seuil statistique intermédiaire $K_{int}$ et le deuxième seuil statistique $K_2$, et si la valeur du maximum d'enveloppe MaxEnv(Swf) est supérieure à un deuxième seuil d'enveloppe $ME_2$, alors le deuxième indicateur Ind2 est mis à une valeur indiquant une détection d'arc électrique positive pour le sous signal temporel numérisé Sw considéré.

De préférence $K_{int}=3,3$ et $ME_2=0,03$

On notera également que $K_2>K1$.

Enfin, dans l'étape de détection 54, la valeur du coefficient de variation calculée lors de l'étape de calcul de coefficient de variation 48 est utilisée pour effectuer un troisième test de détection de présence d'arc électrique.

La valeur du coefficient de variation calculée est comparée à une valeur de seuil de variation V, par exemple égale à 15, et de préférence comprise entre 15% et 100%.

En cas de dépassement du seuil de variation, donc si $C_v(S_W) > V$, alors un troisième indicateur $Ind_3$ est mis à une valeur indiquant une détection d'arc électrique positive pour le sous-signal $S_{WF}$ considéré.

Finalement, lors de l'étape de détection 54, plusieurs valeurs calculées pour le sous-signal temporel numérisé correspondant à la fenêtre temporelle courante sont comparées à des seuils, et trois indicateurs de détection de présence d'arc électrique sont mis à jour.

Les trois indicateurs permettent de fournir une indication de détection d'arc électrique, positive ou négative, pour la fenêtre temporelle courante.

Si l'un des trois indicateurs mis à jour $Ind_1$, $Ind_2$ et $Ind_3$ est positif, donc indique une détection positive de présence d'arc électrique, alors l'indication de détection d'arc électrique pour la fenêtre temporelle courante est positive.

Si tous les trois indicateurs $Ind_1$, $Ind_2$ et $Ind_3$ sont négatifs, alors l'indication de détection d'arc électrique pour la fenêtre temporelle courante est négative.

Si l'indication de détection d'arc électrique pour la fenêtre temporelle courante est positive, alors l'étape de détection 54 est suivie de l'étape 60 de décision de présence d'arc en fonction des tests effectués pour une pluralité de sous-signaux temporels numérisés extraits.

Selon un mode de réalisation, l'indication de détection d'arc électrique pour la fenêtre temporelle courante est mise à jour dans une mémoire tampon circulaire, appelée mémoire tampon de détection d'arc, permettant de stocker des résultats des tests de détection pour un nombre N prédéterminé de sous-signaux temporels numérisés, extraits successivement en utilisant une fenêtre temporelle glissante dans le temps de durée $\Delta T$ prédéterminée.

En pratique, l'indication de détection d'arc électrique positive pour la fenêtre temporelle courante est réalisée par la mise à 1 d'un bit correspondant dans la mémoire tampon de détection d'arc, alors qu'une indication de détection négative se traduit par une mise à 0 du bit correspondant.

Par exemple, la taille N de la mémoire tampon de détection d'arc est donnée par la formule :

$$N = \left\|\frac{f_s}{\Delta T - dt}\right\| \text{ (Eq 9)}$$

Où $\|x\|$ est l'arrondi numérique de la valeur x, $f_s$ est la fréquence d'échantillonnage, $\Delta T$ est la durée de fenêtre temporelle et dt la durée de recouvrement entre deux fenêtres temporelles successives.

Il est déterminé, lors de l'étape de 60 de décision de présence d'arc si le nombre n d'indications de détection positive par sous-signal temporel numérisé est supérieur ou égal à un seuil de détection calculé en fonction de N, par exemple 0,3xN.

D'une manière générale, un coefficient P représentatif d'un taux d'indications de détections positives parmi les N dernières détections de présence d'arc effectuées est utilisé et il est vérifié si $n \geq P \times N$.

En pratique, lorsque l'indication de détection d'arc électrique est un bit égal à 1, il suffit de sommer l'ensemble des valeurs mémorisées dans la mémoire tampon de détection d'arc pour calculer la valeur n.

Lorsque la décision est positive, un signal de déclenchement de l'unité de sécurité est envoyé à l'étape de déclenchement de sécurité 62, pour induire une ouverture du circuit.

En cas de décision négative, l'étape 60, ainsi que l'étape de détection 54 en cas de détection négative pour l'ensemble des tests effectués, est suivie de l'étape 44 d'extraction d'échantillons d'un sous-signal temporel numérisé pour une nouvelle fenêtre temporelle courante, comprise entre $T_0+dt$ et $T_0+dt+\Delta T$.

En variante, seul le premier test de détection basé sur la statistique d'ordre quatre calculée pour chaque sous-signal temporel numérisé extrait est utilisée. Cette variante est plus rapide d'un point de vue calculatoire.

Dans une autre variante, l'étape 48 n'est effectuée que si la valeur de kurtosis calculée pour un sous-signal temporel numérisé considéré est comprise entre le premier seuil $K_1$ et le deuxième seuil $K_2$. Ensuite, les étapes 56 et 58 ne sont effectuées que si la valeur de kurtosis calculée pour un sous-signal temporel numérisé filtré considéré est comprise entre le premier seuil $K_1$ et le deuxième seuil $K_2$ et que la valeur du coefficient de variation est inférieure au seuil de variation. Dans cette variante, les premier, deuxième et troisième tests de détection ne sont pas tous effectués systématiquement, ils sont effectués séparément et conditionnellement au résultat d'un test précédent. Du temps et des ressources calculatoires sont économisés dans cette variante de réalisation.

Dans le cas où les trois tests de détection de présence d'arc sont effectués, il est possible de détecter plusieurs types d'arcs électriques, en surveillant diverses caractéristiques du signal électrique.

## Revendications

1. Procédé de détection d'arcs électriques pour installations électriques à source de courant continu, mis en oeuvre par un dispositif de détection comportant un processeur de calcul, disposé entre la source de courant continu et une charge, **caractérisé en ce qu'**il comporte des étapes de :

   - obtention (40, 42) d'un signal temporel numérisé à partir du courant électrique fourni par la source de courant continu,
   - pour une pluralité de fenêtres temporelles successives de durée temporelle prédéterminée :

      - extraction (44) d'un sous-signal temporel numérisé dudit signal temporel numérisé correspondant à une fenêtre temporelle courante,
      - application (46) d'un filtrage passe-bande audit sous-signal temporel numérisé,
      - calcul (50, 52) d'une valeur statistique d'ordre quatre du sous-signal temporel numérisé filtré,
      - comparaison (54) de la valeur statistique d'ordre quatre calculée à un premier seuil statistique et/ou à un deuxième seuil statistique, et dans le cas où la valeur statistique d'ordre quatre est inférieure au premier seuil statistique, ou dans le cas où la valeur statistique d'ordre quatre est supérieure au deuxième seuil statistique, mémorisation d'une indication de détection positive pour la fenêtre temporelle courante,

      - détection (60) de présence d'arc électrique lorsque le nombre d'indications de détection positive mémorisées dépasse un seuil de détection prédéterminé.

2. Procédé de détection d'arcs électriques selon la revendication 1, **caractérisé en ce qu'**il comporte, pour un dit sous-signal temporel numérisé correspondant à une fenêtre temporelle courante, une détermination (56, 58) d'une valeur de maximum d'enveloppe du sous-signal temporel numérisé, et une mise à jour de ladite indication de détection positive en fonction de la valeur statistique d'ordre quatre calculée et de la valeur de maximum d'enveloppe calculée.

3. Procédé de détection d'arcs électriques selon la revendication 2, **caractérisé en ce que** la détermination d'une valeur de maximum d'enveloppe du sous-signal temporel numérisé est effectuée lorsque ladite valeur statistique d'ordre quatre est supérieure au premier seuil statistique et inférieure au deuxième seuil statistique.

4. Procédé de détection d'arcs électriques selon l'une des revendications 2 ou 3, **caractérisé en ce qu'**il comporte :

**EP 2 966 461 B1**

- lorsque la valeur statistique d'ordre quatre est supérieure au premier seuil statistique et inférieure à un seuil statistique intermédiaire, une comparaison de la valeur de maximum d'enveloppe à un premier seuil d'enveloppe, et une détection de présence d'arc électrique si de la valeur de maximum d'enveloppe est supérieure audit premier seuil d'enveloppe.

5.  Procédé de détection d'arcs électriques selon la revendication 4, **caractérisé en ce qu'**il comporte :

- lorsque la valeur statistique d'ordre quatre est supérieure au seuil statistique intermédiaire et inférieure au deuxième seuil statistique, une comparaison de la valeur de maximum d'enveloppe à un deuxième seuil d'enveloppe, et une détection de présence d'arc électrique si de la valeur de maximum d'enveloppe est supérieure audit deuxième seuil d'enveloppe.

6.  Procédé de détection d'arcs électriques selon l'une quelconque des revendications 1 ou 2, **caractérisé en ce qu'**il comporte un calcul (48) d'un coefficient de variation fonction de la moyenne et de la valeur statistique d'ordre deux du sous-signal temporel numérisé correspondant à la fenêtre temporelle courante avant filtrage passe-bande, et une mise à jour de ladite indication de détection positive lorsque ledit coefficient de variation dépasse un seuil de variation prédéterminé.

7.  Procédé de détection d'arcs électriques selon l'une quelconque des revendications 1 à 6, **caractérisé en ce qu'**il comporte, pour chaque fenêtre temporelle courante, la mémorisation d'une indication de détection d'arc électrique dans une mémoire tampon circulaire de taille prédéterminée.

8.  Procédé de détection d'arcs électriques selon la revendication 7, **caractérisé en ce que** ledit seuil de détection est calculé en fonction de la taille de la mémoire tampon circulaire.

9.  Procédé de détection d'arcs électriques selon l'une quelconque des revendications 1 à 8, **caractérisé en ce que** deux fenêtres temporelles successives présentent un recouvrement d'une durée de recouvrement prédéterminée.

10. Procédé de détection d'arcs électriques selon l'une quelconque des revendications 1 à 9, **caractérisé en ce que** le filtrage passe-bande (46) est défini par une première fréquence F1 et une deuxième fréquence F2, ladite première fréquence étant fonction d'une fréquence de coupure de ladite charge, ladite deuxième fréquence étant fonction d'une fréquence d'échantillonnage d'un convertisseur analogique-numérique permettant d'obtenir ledit signal temporel numérisé.

11. Dispositif de détection d'arcs électriques pour installations électriques à source de courant continu, comportant un processeur de calcul, disposé entre la source de courant continu et une charge, **caractérisé en ce qu'**il comporte :

- un module d'obtention d'un signal temporel numérisé à partir du courant électrique fourni par la source de courant continu,
pour application à une pluralité de fenêtres temporelles successives de durée temporelle prédéterminée,

- une unité d'extraction (22) d'un sous-signal temporel numérisé dudit signal temporel numérisé correspondant à une fenêtre temporelle courante,
- un module de filtrage (24) passe-bande audit sous-signal temporel numérisé,
- un module (26) de calcul d'une valeur statistique d'ordre quatre du sous-signal temporel numérisé filtré,
- un module de décision (32) apte à effectuer une comparaison de la valeur statistique d'ordre quatre calculée à un premier seuil statistique et/ou à un deuxième seuil statistique, et dans le cas où la valeur statistique d'ordre quatre est inférieure au premier seuil statistique, ou dans le cas où la valeur statistique d'ordre quatre est supérieure au deuxième seuil statistique, une mémorisation d'une indication de détection positive pour la fenêtre temporelle courante,

- le module de décision (32) étant apte à détecter de présence d'arc électrique lorsque le nombre d'indications de détection positive mémorisées dépasse un seuil de détection prédéterminé.

12. Dispositif de détection d'arcs électriques selon la revendication 11, **caractérisé en ce qu'**il comporte un module déclenchement (34) d'une unité de sécurité en réponse à un signal de déclenchement envoyé par le module de décision (32).

13. Dispositif de détection d'arcs électriques selon l'une quelconque des revendications 11 ou 12, **caractérisé en ce que** l'unité d'extraction (22) d'un sous-signal temporel numérisé dudit signal temporel numérisé correspondant à une fenêtre temporelle courante comporte un capteur de courant électrique et un convertisseur analogique-numérique ayant une fréquence d'échantillonnage donnée.

14. Dispositif de détection d'arcs électriques selon la revendication 13, **caractérisé en ce que** le module de filtrage (24) passe-bande est apte à effectuer un filtrage entre une première fréquence F1 et une deuxième fréquence F2, ladite première fréquence étant fonction d'une fréquence de coupure de ladite charge, ladite deuxième fréquence étant fonction de la fréquence d'échantillonnage.

15. Dispositif de détection d'arcs électriques selon l'une quelconque des revendications 11 à 14, **caractérisé en ce qu'**il comporte un module (28) de calcul d'enveloppe dudit sous-signal temporel numérisé correspondant à une fenêtre temporelle courante, une valeur de maximum d'enveloppe du sous-signal temporel numérisé étant transmise audit module de décision (32).

16. Dispositif de détection d'arcs électriques selon l'une quelconque des revendications 11 à 15, **caractérisé en ce qu'**il comporte un module (30) de calcul de variation apte à calculer un coefficient de variation fonction de la moyenne et de la valeur statistique d'ordre deux du sous-signal temporel numérisé correspondant à la fenêtre temporelle courante avant filtrage passe-bande, et à transmettre le coefficient de variation calculé audit module de décision (32).

**Patentansprüche**

1. Verfahren zum Detektieren von Lichtbögen für elektrische Anlagen mit einer Gleichstromquelle, ausgeführt von einer Detektionsvorrichtung, die einen Rechenprozessor aufweist, der zwischen der Gleichstromquelle und einer Last angeordnet ist, **dadurch gekennzeichnet, dass** es die Schritte umfasst:

   - Erhalten (40, 42) eines digitalisierten Zeitsignals aus einem von der Gleichstromquelle gelieferten elektrischen Stroms,
   - für eine Mehrzahl von aufeinanderfolgenden Zeitfenstern mit vorbestimmter Zeitdauer:

      - Extrahieren (44) eines digitalisierten Subzeitsignals des digitalisierten Zeitsignals entsprechend einem aktuellen Zeitfenster,
      - Anwenden (46) einer Bandpassfilterung des digitalisierten Subzeitsignals,
      - Berechnen (50, 52) eines statistischen Wertes vierter Ordnung des gefilterten digitalisierten Subzeitsignals,
      - Vergleichen (54) des berechneten statistischen Wertes vierter Ordnung mit einer ersten statistischen Schwelle und/oder einer zweiten statistischen Schwelle und in dem Fall, in dem der statistische Wert vierter Ordnung kleiner als die erste statistische Schwelle ist oder in dem Fall, in dem der statistische Wert vierter Ordnung größer als die zweite statistische Schwelle ist, Speichern einer Angabe einer positiven Detektion für das aktuelle Zeitfenster,

      - Detektieren (60) des Vorhandenseins eines Lichtbogens, wenn die Zahl der gespeicherten Angaben einer positiven Detektion eine vorbestimmte Detektionsschwelle überschreitet.

2. Verfahren zum Detektieren von Lichtbögen nach Anspruch 1, **dadurch gekennzeichnet, dass** es für ein sogenanntes digitalisiertes Subzeitsignal entsprechend einem aktuellen Zeitfenster eine Bestimmung (56, 58) eines Hüllkurvenmaximalwerts des digitalisierten Subzeitsignals und eine Aktualisierung der Angabe einer positiven Detektion abhängig von dem berechneten statistischen Wert vierter Ordnung und des berechneten Hüllkurvenmaximalwerts umfasst.

3. Verfahren zum Detektieren von Lichtbögen nach Anspruch 2, **dadurch gekennzeichnet, dass** die Bestimmung eines Hüllkurvenmaximalwerts des digitalisierten Subzeitsignals ausgeführt wird, wenn der statistische Wert vierter Ordnung größer als die erste statistische Schwelle und kleiner als die zweite statistische Schwelle ist.

4. Verfahren zum Detektieren von Lichtbögen nach einem der Ansprüche 2 oder 3, **dadurch gekennzeichnet, dass** es umfasst:

   - Vergleichen des Hüllkurvenmaximalwerts mit einer ersten Hüllkurvenschwelle der und Detektieren des Vorhandenseins eines Lichtbogens, wenn der Hüllkurvenmaximalwert größer als die erste Hüllkurvenschwelle ist, wenn der statistische Wert vierter Ordnung größer als die erste statistische Schwelle und kleiner als eine statistische Zwischenschwelle ist.

5. Verfahren zum Detektieren von Lichtbögen nach Anspruch 4, **dadurch gekennzeichnet, dass** es umfasst:

- wenn der statistische Wert vierter Ordnung größer als die statistische Zwischenschwelle ist und kleiner als die zweite statistische Schwelle ist, Vergleichen des Hüllkurvenmaximalwerts mit einer zweiten Hüllkurvenschwelle und Detektieren des Vorhandenseins eines Lichtbogens, wenn der Hüllkurvenmaximalwert größer als die zweite Hüllkurvenschwelle ist.

6. Verfahren zum Detektieren von Lichtbögen nach einem beliebigen der Ansprüche 1 oder 2, **dadurch gekennzeichnet, dass** es eine Berechnung (48) eines Variationskoeffizienten als Funktion des Mittels und des statistischen Werts zweiter Ordnung des digitalisierten Subzeitsignals entsprechend dem aktuellen Zeitfenster vor der Bandpassfilterung und eine Aktualisierung der Angabe einer positiven Detektion, wenn der Variationskoeffizient eine vorbestimmte Variationsschwelle überschreitet, aufweist.

7. Verfahren zum Detektieren von Lichtbögen nach einem beliebigen der Ansprüche 1 bis 6, **dadurch gekennzeichnet, dass** es für jedes aktuelle Zeitfenster die Speicherung einer Angabe des Detektierens eines Lichtbogens in einem Ringpufferspeicher von vorbestimmter Größe umfasst.

8. Verfahren zum Detektieren von Lichtbögen nach Anspruch 7, **dadurch gekennzeichnet, dass** die Detektionsschwelle abhängig von der Größe des Ringpufferspeichers berechnet wird.

9. Verfahren zum Detektieren von Lichtbögen nach einem beliebigen der Ansprüche 1 bis 8, **dadurch gekennzeichnet, dass** zwei aufeinanderfolgende Zeitfenster eine Bedeckung einer vorbestimmten Bedeckungsdauer aufweisen.

10. Verfahren zum Detektieren von Lichtbögen nach einem beliebigen der Ansprüche 1 bis 9, **dadurch gekennzeichnet, dass** die Bandpassfilterung (46) durch eine erste Frequenz F1 und eine zweite Frequenz F2 definiert wird, wobei die erste Frequenz abhängig von einer Grenzfrequenz der Last ist und die zweite Frequenz abhängig von einer Abtastfrequenz eines Analog-Digital-Wandlers ist, der den Erhalt des digitalisierten Zeitsignals ermöglicht.

11. Vorrichtung zum Detektieren von Lichtbögen für elektrische Anlagen mit einer Gleichstromquelle und einer Last, **dadurch gekennzeichnet, dass** sie umfasst:

- ein Modul zum Gewinnen eines digitalisierten Zeitsignals aus einem von der Gleichstromquelle gelieferten elektrischen Strom,
für eine Anwendung auf eine Mehrzahl von aufeinanderfolgenden Zeitfenstern mit vorgegebener Zeitdauer

- eine Einheit (22) zum Extrahieren eines digitalisierten Subzeitsignals des digitalisierten Signals entsprechend einem aktuellen Zeitfenster,
- ein Modul (24) zur Bandpassfilterung des digitalisierten Subzeitsignals,
- ein Modul (26) zur Berechnung eines statistischen Wertes vierter Ordnung des gefilterten digitalisierten Subzeitsignals,
- ein Entscheidungsmodul (32), das geeignet ist, einen Vergleich des statistischen berechneten Wertes vierter Ordnung mit einer ersten statistischen Schwelle und/oder einer zweiten statistischen Schwelle durchzuführen, und in dem Fall, in dem der statistische Wert vierter Ordnung kleiner als die erste statistische Schwelle ist, oder in dem Fall, in dem der statistische Wert vierter Ordnung größer als die zweite statistische Schwelle ist, Speichern einer Angabe einer positiven Detektion für das aktuelle Zeitfenster,

- wobei das Entscheidungsmodul (32) geeignet ist, das Vorhandensein eines Lichtbogens zu detektieren, wenn die Anzahl von gespeicherten Angaben einer positiven Detektion eine vorgegebene Detektionsschwelle überschreitet.

12. Vorrichtung zum Detektieren von Lichtbögen nach Anspruch 11, **dadurch gekennzeichnet, dass** sie ein Modul (34) zum Auslösen einer Sicherheitseinheit abhängig von einem von dem Entscheidungsmodul (32) gesendeten Auslösesignal aufweist.

**13.** Vorrichtung zum Detektieren von Lichtbögen nach einem beliebigen der Ansprüche 11 oder 12, **dadurch gekennzeichnet, dass** die Einheit (22) zum Extrahieren eines digitalisierten Subzeitsignals aus dem digitalisierten Zeitsignal entsprechend einem aktuellen Zeitfenster einen Stromsensor und einen Analog-Digital-Wandler mit einer vorgegebenen Abtastfrequenz aufweist.

**14.** Vorrichtung zum Detektieren von Lichtbögen nach Anspruch 13, **dadurch gekennzeichnet, dass** das Bandpassfiltermodul (24) geeignet ist, eine Filterung zwischen einer ersten Frequenz F1 und einer zweiten Frequenz F2 durchzuführen, wobei die erste Frequenz abhängig von der Grenzfrequenz der Last und die zweite Frequenz abhängig von der Abtastfrequenz ist.

**15.** Vorrichtung zum Detektieren von Lichtbögen nach einem beliebigen der Ansprüche 11 bis 14, **dadurch gekennzeichnet, dass** sie ein Modul (28) zum Berechnen der Hüllkurve des digitalisierten Subzeitsignals entsprechend einem aktuellen Zeitfenster aufweist, wobei ein Hüllkurvenmaximalwert des digitalisierten Subzeitsignals an das Entscheidungsmodul (32) geliefert wird.

**16.** Vorrichtung zum Detektieren von Lichtbögen nach einem beliebigen der Ansprüche 11 bis 15, **dadurch gekennzeichnet, dass** sie ein Modul (30) zum Berechnen einer Variation aufweist, das geeignet ist, einen Variationskoeffizienten abhängig von dem Mittel und dem statistischen Wert zweiter Ordnung des digitalisierten Subzeitsignals entsprechend dem aktuellen Zeitfenster vor der Bandpassfilterung zu berechnen und den berechneten Variationskoeffizienten an das Entscheidungsmodul (32) zu liefern.


**Claims**

**1.** Method for detecting electric arcs for electrical systems with d.c. current source implemented by a detection device comprising a calculation processor arranged between the d.c. current source and a load, **characterised in that** it comprises the steps of:

- obtaining (40, 42) a digital time signal from the electric current supplied by the d.c. current source,
- for a plurality of successive time windows of predetermined time duration:

  ◦ extracting (44) a digital time sub-signal of said digital time signal corresponding to a current time window,
  ◦ applying (46) a band-pass filtering to said digital time sub-signal,
  ◦ calculating (50, 52) a fourth-order statistical value of the filtered digital time sub-signal,
  ◦ comparing (54) the calculated fourth-order statistical value to a first statistical threshold and/or to a second statistical threshold, and in the case where the fourth-order statistical value is lower than the first statistical threshold or in the case where the fourth-order statistical value is higher than the second statistical threshold, storing a positive detection indication for the current time window,
  ◦ detecting (60) the presence of an electric arc when the number of positive detection indications stored exceeds a predetermined detection threshold.

**2.** Method for detecting electric arcs according to claim 1, **characterised in that** for a said digital time sub-signal corresponding to a current time window, it comprises a determination (56, 58) of a maximum envelope value of the digital time sub-signal and an updating of said positive detection indication as a function of the calculated fourth-order statistical value and the calculated maximum envelope value.

**3.** Method for detecting electric arcs according to claim 2, **characterised in that** the determination of a maximum envelope value of the digital time sub-signal is conducted when said fourth-order statistical value is higher than the first statistical threshold and lower than the second statistical threshold.

**4.** Method for detecting electric arcs according to one of claims 2 or 3, **characterised in that** it comprises:

- when the fourth-order statistical value is higher than the first statistical threshold and lower than an intermediate statistical threshold, a comparison of the maximum envelope value to a first envelope threshold and a detection of the presence of an electric arc if the maximum envelope value is higher than said first envelope threshold.

**5.** Method for detecting electric arcs according to claim 4, **characterised in that** it comprises:

• when the fourth-order statistical value is higher than the intermediate statistical threshold and lower than the second statistical threshold, a comparison of the maximum envelope value to a second envelope threshold and a detection of the presence of an electric arc if the maximum envelope value is higher than said second envelope threshold.

6. Method for detecting electric arcs according to any one of claims 1 or 2, **characterised in that** it comprises a calculation (48) of a coefficient of variation dependent on the mean and on the second-order statistical value of the digital time sub-signal corresponding to the current time window before band-pass filtering and an updating of said positive detection indication when said coefficient variation exceeds a predetermined variation threshold.

7. Method for detecting electric arcs according to any one of claims 1 to 6, **characterised in that** for each current time window it comprises storage of a detection indication of an electric arc in a circular buffer of predetermined size.

8. Method for detecting electric arcs according to claim 7, **characterised in that** said detection threshold is calculated as a function of the size of the circular buffer.

9. Method for detecting electric arcs according to any one of claims 1 to 8, **characterised in that** two successive time windows show an overlap of a predetermined overlap duration.

10. Method for detecting electric arcs according to any one of claims 1 to 9, **characterised in that** the band-pass filtering (46) is defined by a first frequency F1 and a second frequency F2, wherein said first frequency is dependent on a cut-off frequency of said load and said second frequency is dependent on a sampling frequency of an analogue to digital converter enabling said digital time signal to be obtained.

11. Device for detecting electric arcs for electrical systems with d.c. current source comprising a calculation processor arranged between the d.c. current source and a load, **characterised in that** it comprises:

• a module for obtaining a digital time signal from the electric current supplied by the d.c. current source, for application for a plurality of successive time windows of predetermined time duration,
• a unit (22) for extracting a digital time sub-signal of said digital time signal corresponding to a current time window,
• a band-pass filtering module (24) for said digital time sub-signal,
• a module (26) for calculating a fourth-order statistical value of the filtered digital time sub-signal,
• a decision module (32) capable of performing a comparison of the calculated fourth-order statistical value to a first statistical threshold and/or to a second statistical threshold, and in the case where the fourth-order statistical value is lower than the first statistical threshold or in the case where the fourth-order statistical value is higher than the second statistical threshold, of storing a positive detection indication for the current time window,
• wherein the decision module (32) is capable of detecting the presence of an electric arc when the number of positive detection indications stored exceeds a predetermined detection threshold.

12. Device for detecting electric arcs according to claim 11, **characterised in that** it comprises a module (34) for activating a safety unit in response to an activation signal sent by the decision module (32).

13. Device for detecting electric arcs according to any one of claims 11 or 12, **characterised in that** the unit (22) for extracting a digital time sub-signal of said digital time signal corresponding to a current time window comprises an electric current sensor and an analogue to digital converter having a given sampling frequency.

14. Device for detecting electric arcs according to claim 13, **characterised in that** the band-pass filtering module (24) is capable of performing a filtering operation between a first frequency F1 and a second frequency F2, wherein said first frequency is dependent on a cut-off frequency of said load and said second frequency is dependent on the sampling frequency.

15. Device for detecting electric arcs according to any one of claims 11 to 14, **characterised in that** it comprises a module (28) for calculating the envelope of said digital time sub-signal corresponding to a current time window, wherein a maximum envelope value of the digital time sub-signal is transmitted to said decision module (32).

16. Device for detecting electric arcs according to any one of claims 11 to 15, **characterised in that** it comprises a module (30) for variation calculation capable of calculating a coefficient of variation dependent on the mean and on the second-order statistical value of the digital time sub-signal corresponding to the current time window before band-pass filtering, and of transmitting the calculated coefficient of variation to said decision module (32).

FIG.1

FIG.2

FIG.3

FIG.4

FIG.5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

• **XIU YAO et al.** The detection of DC arc fault : Experimental study and fault recognition. *Applied Power Electronics Conference and Exposition (APEC),* 05 Février 2012, 1720-1727